# EUROPÄISCHE PATENTSCHRIFT

(11) **EP 0 483 228 B1**
(45) Veröffentlichungstag und Bekanntmachung des Hinweises auf die Patenterteilung: **13.11.1996**
(21) Anmeldenummer: 90911281.5
(22) Anmeldetag: 01.08.1990
(51) Int. Cl.: G01R 33/30

(54) **KERNSPINRESONANZ-SPEKTROMETER**
NUCLEAR MAGNETIC RESONANCE SPECTROMETER
SPECTROMETRE A RESONANCE MAGNETIQUE NUCLEAIRE

(30) Priorität: 15.05.1990 FR 9006217
(43) Veröffentlichungstag der Anmeldung: 06.05.1992
(73) Patentinhaber: Bruker Analytische Messtechnik GmbH, D-76287 Rheinstetten (DE)
(72) Erfinder: MÜLLER, Detlef, D-7502 Malsch (DE); COUTURES, J.P. Ctre Nat. de la Rech. Scientifique, F-45071 Orléans Cédex 2 (FR); TAULELLE, Francis, F-92340 Bourg-la-Reine (FR); MASSIOT, Dominique, F-45000 Orléans (FR)
(74) Vertreter: Witte, Alexander, Dr.-Ing.
(86) Internationale Anmeldenummer: DE9000588
(87) Internationale Veröffentlichungsnummer: WO9118300

(56) Entgegenhaltungen:
- WO-A-89/12806
- FR-A- 2 628 214
- ANALYTICAL CHEMISTRY, Band 60, Nr. 9, 1. May 1988, American Chemical Society, Washington DC, US; J.F. HAW : "Variable-temperature solid-state NMR spectroscopy", Seiten 559-570
- BRUKER-REPORT, Band 2, 1988, Karlsruhe, (DE), J.P. COUTURES et al.: "NMR spectroscopy at very high temperatures", Seiten 9-11
- REVIEW OF SCIENTIFIC INSTRUMENTS, Band 51, Nr. 4, April 1980, American Institute of Physics, New York, US; T.A. YAGER et al.: "Laser-heated high-temperature EPR spectroscopy", Seiten 464-466

## Beschreibung

Die Erfindung betrifft ein Kernspinresonanz-Spektrometer mit einem Probengefäß zur Aufnahme einer Probe und mit einem Laser, dessen Laserstrahl zum Aufheizen der Probe auf eine Oberfläche des Probengefäßes gerichtet ist.

Ein Kernspinresonanz-Spektrometer der vorstehend genannten Art ist aus dem Dokument DE-Z "BRUKER REPORT", Heft 2 (1988), Seiten 9 bis 11 bekannt.

Mit dem bekannten Spektrometer können Messungen von Proben bei sehr hohen Temperaturen von bis zu 1.000°C ausgeführt werden. Die Probe befindet sich dabei freiliegend am unteren Ende eines Rotors. Der Rotor ist im Magnetfeld eines supraleitenden Magneten drehbar angeordnet. Von der Unterseite des Probenkopfes wird ein Laserstrahl durch eine geeignete Durchgangsöffnung auf die Probe geleitet.

Damit ist es zwar möglich, bei Kernspinresonanz-Messungen mit um die vertikale Achse rotierender Probe eine Aufheizung der Probe mittels eines Laserstrahls vorzunehmen, eine Temperaturkontrolle ist dabei jedoch nur mit großem Aufwand möglich.

Aus dem Dokument FR-A-2 628 214 ist ein weiteres Kernspinresonanz-Spektrometer bekannt, bei dem die Probe in einem vertikalachsigen festmontierten Probengefäß im Probenraum eines Magneten angeordnet ist. Auch bei diesem bekannten Spektrometer wird eine Aufheizung mittels eines Laserstrahls vorgenommen.

Der Laserstrahl wird von der Unterseite des Probenkopfes her zugeführt.

Bei dieser bekannten Anordnung wird die Temperatur des Probengefäßes mit der darin befindlichen Probe im Bereich zwischen 400°C und 1.000°C dadurch eingestellt, daß die Intensität des Laserstrahls variiert wird. Zu diesem Zwecke ist ein Pyrometer vorgesehen, das von der Oberseite des Probengefäßes her dessen Wärmeabstrahlung erfaßt, verarbeitet und einem Temperaturregler zuführt.

Die bekannte Anordnung ist daher relativ umständlich und aufwendig, was die Einstellung der Temperatur der Probe angeht, im übrigen wird bei diesem bekannten Spektrometer auch der Raum oberhalb des Probengefäßes benötigt. Dies führt in der Praxis zu Schwierigkeiten, weil dort in der Regel die mechanischen Halteelemente für den Probenkopf vorgesehen sind.

Aus dem Dokument US-A-4 201 941 ist ein Kernspinresonanz-Spektrometer bekannt, bei dem in einem Probenkopf ein Probenhalter vorgesehen ist, der wiederum einen Rotor zur Aufnahme einer Probensubstanz enthält. Der Rotor ist um eine Achse drehbar, die um den sogenannten "magischen Winkel" von 54,7° zur Längsachse des Probenkopfes und damit zur Richtung des umgebenden Konstant-Magnetfeldes geneigt ist.

Aus dem Dokument US-Z "Review of Scientific Instruments" (51), Heft 4, April 1980, Seiten 464-466 ist ein Elektronenspinresonanz-Spektrometer bekannt, bei dem die zu untersuchende Probe auf einem Teller angeordnet ist. Der Teller wird seinerseits von unten durch einen langen Stab gehalten, der sich mit dem Teller axial in einem isolierten Glasrohr befindet. Von der entgegengesetzten Seite des Glasrohres kann ein Laserstrahl unmittelbar auf die Probe gerichtet werden.

Bei allen bekannten Anordnungen, bei denen die Probe selbst oder ein Probengefäß mittels eines Laserstrahls aufgeheizt wird, ergibt sich folgender wesentlicher Nachteil:

Wenn der Laserstrahl auf die Probe oder das Probengefäß gerichtet wird, so wird ein Teil des eingestrahlten Lichtes zwar absorbiert und in Wärme umgesetzt, ein weiterer Teil wird jedoch reflektiert. Dieses reflektierte Sekundärlicht fällt auf die Bauteile des Probenkopfes, die das Probengefäß oder die Probe selbst umgeben. Auf diese Weise ergibt sich eine unerwünschte Erwärmung der umliegenden Bauteile, insbesondere der Hochfrequenz-Spule, was zu Verlusten im Signal/Rauschverhältnis führt. Sofern der Probenkopf einen luftgelagerten Rotor umfaßt, kann in diesem Fall durch Erwärmung der Luftlager ein instabiler Rotationszustand eintreten.

Der Erfindung liegt daher die Aufgabe zugrunde, ein Kernspinresonanz-Spektrometer der eingangs genannten Art dahingehend weiterzubilden, daß die genannten Nachteile vermieden werden. Insbesondere soll möglichst der gesamte auf die Probe oder das Probengefäß gerichtete Laserstrahl in Wärme umgesetzt werden.

Diese Aufgabe wird gemäß dem eingangs genannten Kernspinresonanz-Spektrometer erfindungsgemäß dadurch gelöst, daß die Oberfläche in einem Hohlraum des Probengefäßes ausgebildet ist, daß der Hohlraum eine einzige Zugangsöffnung aufweist, und daß der Querschnitt der Zugangsöffnung im wesentlichen dem Querschnitt des Laserstrahls oder der Breite eines Fokuspunktes des Laserstrahls entspricht.

Die Erfindung hat damit den Vorteil, daß bei der an sich bekannten Aufheizung des Probengefäßes mittels eines Laserstrahls die Energie des Laserstrahls nahezu vollkommen in eine Aufwärmung des Probengefäßes und damit der Probe umgesetzt wird, während umliegende Bauteile keine direkte Erwärmung durch den Laserstrahl erfahren.

Die gewünschte Definiertheit des Lichtabsorptions-Verhaltens wird besonders gut bei keramischen Werkstoffen erreicht. Bei bevorzugten Ausgestaltungen der Erfindung wird daher eine Keramikoberfläche für die Einstrahlung des Laserstrahls vorgesehen. Vorzugsweise besteht das gesamte Probengefäß bzw. der gesamte Rotor zu diesem Zweck aus einer Keramik.

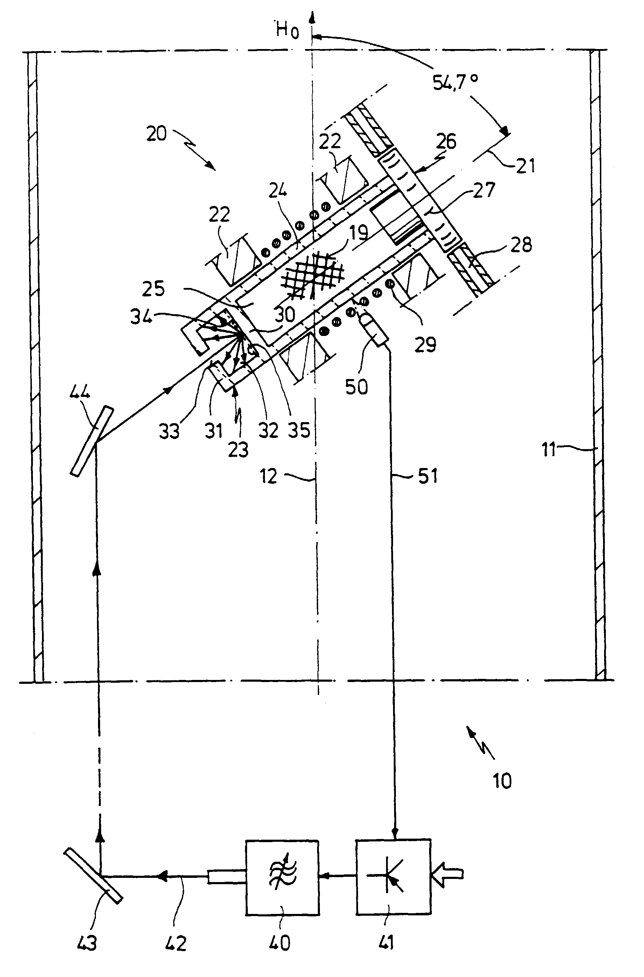

Ein Ausführungsbeispiel der Erfindung ist in der Zeichnung dargestellt und wird in der nachfolgenden Beschreibung näher erläutert. Die einzige Figur zeigt eine schematisierte Seitenansicht, teilweise im Schnitt, eines Ausführungsbeispiels der Erfindung.

In der Figur bezeichnet 10 insgesamt einen Probenkopf eines Kernspinresonanz-Spektrometers von an sich bekannter Bauart. Der Probenkopf 10 ist nach außen durch ein schematisch angedeutetes Rohr 11 begrenzt. Das Rohr 11 definiert zugleich mit seiner Längsachse eine erste Achse 12. Die erste Achse 12 liegt in der Richtung des Konstant-Magnetfeldes H₀ eines Magnetsystems. Das Magnetsystem ist aus Gründen der Übersichtlichkeit in der Figur nicht dargestellt.

Um Materialeigenschaften einer Probe 19 mittels Kernspinresonanz zu messen, ist die Probe 19 in einem insgesamt mit 20 bezeichneten Probenhalter angeordnet. Der Probenhalter 20 ist in Richtung einer zweiten Achse 21 aufgebaut, die mit der ersten Achse 12 einen Winkel vom 54,7°, den sogenannten "magischen Winkel" einschließt. Es versteht sich jedoch, daß die Erfindung auf diese Winkelangaben nicht beschränkt ist, sondern daß vielmehr auch andere Winkel eingestellt werden können, ohne den Rahmen der vorliegenden Erfindung zu verlassen.

Der Probenhalter 20 umfaßt in der Figur nur schematisch angedeutete stationäre Lager 22, um einen Rotor 23 in Richtung der zweiten Achse 21 drehbar zu lagern.

Der Rotor 23 besteht im wesentlichen aus einem zylindrischen Röhrchen 24 aus keramischem Material, das einen Innenraum 25 zur Aufnahme der Probe 19 umschließt. Das Röhrchen 24 ist mittels eines Deckels 26 verschlossen.

Der Deckel 26 ist an seinem Umfang mit turbinenschaufelartigen Einprägungen 27 versehen. Die Einprägungen 27 befinden sich nahe von Düsen 28, die in an sich bekannter Weise einen Gasstrom auf die Einprägungen 27 in Umfangsrichtung leiten, um eine Rotation des Rotors 23 mit einer Umdrehungsfrequenz von einigen kHz zu bewirken.

Mit 29 ist noch eine Hochfrequenz-Spule angedeutet, mittels deren das für Kernresonanz-Messungen erforderliche Hochfrequenz-Magnetfeld auf die Probe 19 eingestrahlt werden kann.

Wie die Figur deutlich zeigt, grenzt ein Boden 30 des Röhrchens 24 an eine Kammer 31, die vorzugsweise einstückig an das Röhrchen 24 angeformt ist und ebenfalls aus einem keramischen Werkstoff besteht.

Die Kammer 31 umschließt einen Hohlraum 32. Der Hohlraum 32 ist nur über eine einzige Öffnung 33 mit dem Außenraum verbunden. Mit 34 ist eine innere Oberfläche des Hohlraums 32 bezeichnet. Die Oberfläche 34 kann mit einem geeigneten lichtabsorbierenden Belag 35 versehen oder aufgerauht sein.

Unterhalb des Probenhalters 20 befindet sich ein Laser 40, beispielsweise ein CO₂-Laser mit einer Wellenlänge im Bereich von 10 um und einer maximalen Ausgangsleistung zwischen 10 und 100 W.

Der Laser 40 ist mittels eines Steuergerätes 41, das in den Laser 40 integriert sein kann, in seiner Intensität einstellbar.

Der Laser 40 sendet einen Laserstrahl 42 aus, der mittels Spiegeln 43, 44 umgelenkt wird, um dann durch die Öffnung 33 in den Hohlraum 32 einzutreten und auf die Oberfläche 34 aufzutreffen.

Wie in der Figur gezeigt, wird der Laserstrahl 42 beim Auftreffen auf die Oberfläche 34 reflektiert, und die reflektierten Lichtstrahlen fallen wiederum auf Bereiche der Oberfläche 34, können jedoch nicht aus der Kammer 31 austreten, weil diese, wie erwähnt, bis auf die Öffnung 33 allseits geschlossen ist. Durch geeignete Wahl der Oberfläche 34 bzw. eines Belages 35 kann nun ein besonders diffuses Reflektionsverhalten der Oberfläche 34 eingestellt werden, um ein Wieder-Austreten auch nur eines kleinen Teils des eingestrahlten Laserlichtes durch die Öffnung 33 zu verhindern. Selbstverständlich wird die Öffnung 33 in ihrem Querschnitt so klein wie möglich dimensioniert, vorzugsweise ist die Öffnung 33 gerade so groß, wie dies dem Querschnitt des vorzugsweise auf die Öffnung fokussierten Laserstrahls 42 entspricht.

Schließlich ist in der Nähe des Rotors 23 noch eine Infrarot-Diode 50 angeordnet, die über eine Leitung 51 mit dem Steuergerät 41 verbunden ist.

Die Wirkungsweise der Anordnung ist wie folgt:

Um die Temperiereinrichtung für die Probe 19 zu eichen, wird zweckmäßigerweise der Rotor 23 so konzipiert, daß seine Wärmekapazität wesentlich größer ist als die Streuung der Wärmekapazitäten von zu messenden Proben 19. Der Rotor 23 wird dann, entweder leer oder mit einer Probe von durchschnittlichen Eigenschaften befüllt, in den Probenhalter 20 eingesetzt und durch Einblasen von Treibgas durch die Düsen 28 in Rotation versetzt.

Nun wird der Laser 40 eingeschaltet und der Laserstrahl 42 über die Spiegel 43, 44 in die Öffnung 33 gerichtet, die aufgrund ihrer axialen Anordnung während der Rotation des Rotors 23 stets einen Zugang zum Hohlraum 32 freigibt.

Die Intensität des Laserstrahls 42 wird nun durch Einstellen des Steuergerätes 41 variiert, und zugleich wird für diese Kalibrierzwecke mittels der vorzugsweise auf den Rotor 23 fokussierten Infrarot-Diode 50 die Temperatur gemessen, auf die sich der Rotor 23 infolge des einwirkenden Laserstrahls 42 aufheizt.

Am Ende dieses Vorgehens steht ein Protokoll zur Verfügung, bei dem die Temperatur des Rotors und damit auch die Temperatur der Probe über der Laserleistung bzw. der Einstellung des Steuergerätes 41 aufgetragen ist.

Für nachfolgende Messungen braucht daher nur noch im Steuergerät 41 der entsprechend geeichte Wert eingestellt zu werden, der einer bestimmten Intensität des Laserstrahls 42 und damit einer definierten Temperatur des Rotors 23 und der Probe 19 entspricht.

Es wurde bereits erwähnt, daß die zuvor geschilderte Anordnung grundsätzlich unabhängig davon ist, ob der Rotor 23 nun unter dem "magischen Winkel" zur ersten Achse 12 des Konstant-Magnetfeldes Ho angestellt ist oder nicht. So ist z.B. denkbar, den Rotor 23 gleichachsig zur ersten Achse 12 auszurichten, wie dies bei konventionellen Kernresonanz-Messungen üblich ist, weil auch in diesem Falle eine kontrollierte Aufheizung der Probe 19 über die Einstrahlung des Laserstrahls 42 in den Hohlraum 32 möglich ist, auch wenn der Rotor 23 sich dreht.

## Patentansprüche

1. Kernspinresonanz-Spektrometer mit einem Probengefäß (23) zur Aufnahme einer Probe (19) und mit einem Laser (40), dessen Laserstrahl (42) zum Aufheizen der Probe auf eine Oberfläche (34) des Probengefäßes (23) gerichtet ist, dadurch gekennzeichnet, daß die Oberfläche (34) in einem Hohlraum (32) des Probengefäßes (23) ausgebildet ist, daß der Hohlraum (32) eine einzige Zugangsöffnung (33) aufweist, und daß der Querschnitt der Zugangsöffnung (33) im wesentlichen dem Querschnitt des Laserstrahls (42) oder der Breite eines Fokuspunktes des Laserstrahls (42) entspricht.

2. Spektrometer nach Anspruch 1, dadurch gekennzeichnet, daß die Oberfläche (34) mit einer lichtabsorbierenden Beschichtung (35) oder einer Aufrauhung versehen ist.

3. Spektrometer nach Anspruch 1 oder 2, dadurch gekennzeichnet, daß die Oberfläche (34) eine Keramikoberfläche ist.

4. Spektrometer nach einem der Ansprüche 1 bis 3, dadurch gekennzeichnet, daß das Probengefäß als Rotor ausgebildet ist.

5. Spektrometer nach Anspruch 3 und 4, dadurch gekennzeichnet, daß der Rotor (23) im wesentlichen aus einer Keramik besteht.

6. Spektrometer nach Anspruch 4 oder 5, dadurch gekennzeichnet, daß der Rotor (23) um eine Achse (21) drehbar ist, die mit einer vorgegebenen Richtung (12) eines Konstant-Magnetfeldes (H₀) einen spitzen Winkel von vorzugsweise 54,7° einschließt.

7. Spektrometer nach einem der Ansprüche 1 bis 6, dadurch gekennzeichnet, daß der Laserstrahl (42) mittels eines Steuergerätes (41) in seiner Intensität einstellbar ist.

8. Spektrometer nach Anspruch 7, dadurch gekennzeichnet, daß das Steuergerät (41) mit einem Temperatursensor verbunden ist, der an einem Probenhalter (20) angeordnet ist.

9. Spektrometer nach Anspruch 4 und Anspruch 8, dadurch gekennzeichnet, daß der Temperatursensor eine Infrarot-Diode (50) ist, die vorzugsweise die Temperatur der Rotoroberfläche mißt.

## Claims

1. A nuclear magnetic resonance spectrometer comprising a sample receptacle (23) for receiving a sample (19), and a laser (40), a laser beam (42) of which being directed to a surface (34) of the sample receptacle (23) for heating-up the sample, characterized in that the surface (34) is provided within a cavity (32) of the sample receptacle (23), that the cavity has one access opening (33) only, and that the cross-section of the access opening (33) essentially corresponds to the cross-section of the laser beam (42) or to the width of a focal point of the laser beam (42).

2. The spectrometer of claim 1, characterized in that the surface (34) is provided with a light-absorbing lining (35) or with a roughening.

3. The spectrometer of claim 1 or 2, characterized in that the surface (34) is a ceramic surface.

4. The spectrometer of any of claims 1 to 3, characterized in that the sample receptacle is configured as a rotor.

5. The spectrometer of claim 3 or 4, characterized in that the rotor (23) essentially consists of a ceramic.

6. The spectrometer of claim 4 or 5, characterized in that the rotor (23) is adapted to be rotated about an axis (21) enclosing an acute angle of preferably 54,7° with a predetermined direction (12) of a constant magnetic field (H₀).

7. The spectrometer of any of claims 1 to 6, characterized in that the laser beam (42) is adapted to be controlled in its intensity by means of a control unit (41).

8. The spectrometer of claim 7, characterized in that the control unit (41) is connected to a temperature sensor being arranged on a sample holder (20).

9. The spectrometer of claim 4 and claim 8, characterized in that the temperature sensor is an infrared-diode (50), measuring preferably the temperature at the rotor surface.

## Revendications

1. Spectromètre à résonance magnétique nucléaire doté d'un réceptacle à échantillon (23) destiné à recevoir un échantillon (19) et d'un laser (40) dont le rayon laser (42) est dirigé sur une surface (34) du réceptacle à échantillon (23) pour échauffer ledit échantillon, caractérisé en ce que la surface (34) est agencée dans une cavité (32) du réceptacle à échantillon, en ce que la cavité (32) présente un orifice d'accès (33) unique et en ce que la section de l'orifice d'accès (33) correspond sensiblement à la section du rayon laser (42) ou à la largeur d'un point focal du rayon laser (42).

2. Spectromètre selon la revendication 1, caractérisé en ce que la surface (34) est rugueuse ou dotée d'un revêtement (35) absorbant la lumière.

3. Spectromètre selon la revendication 1 ou 2, caractérisé en ce que la surface (34) est réalisée en céramique.

4. Spectromètre selon l'une quelconque des revendications 1 à 3, caractérisé en ce que le réceptacle à échantillon est conçu comme un rotor.

5. Spectromètre selon la revendication 3 et 4, caractérisé en ce que le rotor (23) est essentiellement réalisé en une céramique.

6. Spectromètre selon la revendication 4 ou 5, caractérisé en ce que le rotor (23) est mobile en rotation autour d'un axe (21) formant un angle aigu, de préférence égal à 54,7°, avec une direction prédéterminée (12) d'un champ magnétique constant (H₀).

7. Spectromètre selon l'une des revendications 1 à 6, caractérisé en ce que le rayon laser (42) peut être réglé en intensité au moyen d'un appareil de commande (41).

8. Spectromètre selon la revendication 7, caractérisé en ce que l'appareil de commande (41) est relié à un capteur thermique placé sur un support d'échantillon (20).

9. Spectromètre selon les revendications 4 et 8, caractérisé en ce que le capteur thermique consiste en une diode infrarouge (50) mesurant de préférence la température superficielle du rotor.
